# EUROPEAN PATENT APPLICATION

(11) **EP 1 798 990 A2**
(43) Date of publication of application: **20.06.2007**
(21) Application number: 06025611.2
(22) Date of filing: 11.12.2006
(51) Int. Cl.: H04N 9/04

(54) **Solid-state image pickup device, color separation image pickup optical system**

(30) Priority: 14.12.2005 JP 2005360567
(71) Applicant: SONY CORPORATION, Tokyo (JP)
(72) Inventor: Ohno, Tsuyoshi, Shinagawa-ku, Tokyo (JP); Tamura, Masaki, Shinagawa-ku, Tokyo (JP); Nakanishi, Hitoshi, Shinagawa-ku, Tokyo (JP)
(74) Representative: Müller - Hoffmann & Partner

(57) **Abstract**

A color separation image pickup optical system is which can spectralize light with low noise and can be formed in a minimized size. The color separation image pickup optical system includes a solid-state image pickup device which in turn includes a semiconductor substrate, a plurality of photoelectric conversion elements formed on the semiconductor substrate, a transparent seal member, an a package in which the semiconductor substrate is sealed with the transparent seal member. A color light absorbing member of a single performance is disposed on the transparent seal member side with respect to the photoelectric conversion elements in the package and absorbs color light in a particular visible wavelength region with regard to the photoelectric conversion elements.

## Description

### CROSS REFERENCES TO RELATED APPLICATIONS

The present invention contains subject matter related to Japanese Patent Application JP 2005-360567 filed with the Japanese Patent Office on December 14, 2005, the entire contents of which being incorporated herein by reference.

### BACKGROUND OF THE INVENTION

### 1. Field of the Invention

This invention relates to a solid-state image pickup device, a color separation image pickup optical system and an image pickup apparatus. More particularly, the present invention relates to a color separation image pickup optical system which separates incident light into a plurality of color light components to be received individually by different solid-state image pickup devices, a solid-state image pickup device suitable for use with a color separation image pickup optical system of the type described and an image pickup apparatus in which a color separation image pickup optical system of the type described is incorporated.

### 2. Description of the Related Art

A color separation image pickup optical system is sometimes used in an image pickup apparatus such as a video camera or a still camera. The color separation image pickup optical system includes a color separation optical system and a plurality of solid-state image pickup devices. Optical devices of the color separation optical system and the solid-state image pickup devices are secured to each other by a transparent bonding agent or are disposed with an air layer interposed therebetween. Further, the color separation optical system is formed from a combination of optical devices such as a plurality of prisms and a plurality of filters having wavelength selectivity. Light passing through an image pickup lens enters the color separation optical system, by which it is separated into a plurality of color light components. Although separation into three color lights of green, blue and red is popularly used, also a color serration optical system which separates light into two or four color light components has been proposed. On the emergent side of the color separation optical system, a plurality of solid-state image pickup devices such as CCD (Charge Coupled Device) devices or CMOS (Complementary Metal-Oxide Semiconductor) devices are disposed.

In order to remove unnecessary color light, occasionally a color light reflecting filter formed from a dichroic film is applied to a transparent seal member of solid-state image pickup devices or a color light absorbing filter called trimming filter is provided on each color light emerging face of the color separation optical system. A solid-state image pickup device which adopts a reflecting filter is disclosed, for example, in Japanese Patent Laid-Open No. 2000-134636 (hereinafter referred to as Patent Document 1). A color separation optical system which includes an absorbing filter is disclosed, for example, in Japanese Patent Laid-Open No. 2005-99378 (hereinafter referred to as Patent Document 2).

### SUMMARY OF THE INVENTION

However, where a solid-state image pickup device includes a reflecting film formed from a dichroic film as disclosed in Patent Document 1, upon image pickup under a high luminance light source, it sometimes occurs that damaging light is generated by multiple reflection which occurs between the reflecting filter section and some other optical member or/and the image pickup device and comes up to the image pickup device. On the other hand, where a color separation optical system includes an absorbing filter as disclosed in Patent Document 2, the optical system is liable to have a size increased by the thickness of the absorbing filter. Further, where a reflecting filter or an absorbing filter is provided on an emergent face of a color separation optical system, this makes a factor of increase of the cost.

Therefore, it is demanded to provide a color separation image pickup optical system which can spectralize light with low noise and can be formed in a minimized size, a solid-state image pickup device suitable for use with the color separation image pickup optical system and an image pickup apparatus which suitably incorporates the color separation image pickup optical system.

According to an embodiment of the present invention, there is provided a solid-state image pickup device including a semiconductor substrate, a plurality of photoelectric conversion elements formed on the semiconductor substrate, a transparent seal member, a package in which the semiconductor substrate is sealed with the transparent seal member, and a color light absorbing member of a single performance disposed on the transparent seal member side with respect to the photoelectric conversion elements in the package and configured to absorb color light in a particular visible wavelength region with regard to the photoelectric conversion elements.

In the solid-state image pickup device, the color light absorbing member of a single performance is disposed in the inside of the package thereof. Consequently, color light in the particular visible wavelength region is absorbed by the color light absorbing member provided in the inside of the package. Therefore, only color light components in a predetermined wavelength region having passed through the color light absorbing member come to the photoelectric conversion elements. Therefore, where the solid-state image pickup device is incorporated in a color separation image pickup optical system, a color light absorbing member need not be disposed on the outside of the solid-state image pickup device. Consequently, the color separation image pickup optical system can be formed in a reduced size as much. Further, if a color light absorbing member is additionally disposed on the outside of the solid-state image pickup device, although further miniaturization than ever cannot be anticipated, since object color light can be intercepted doubly, the photoelectric conversion elements can receive desired color light with further reduced noise.

According to another embodiment of the present invention, there is provided a solid-state image pickup device including a semiconductor substrate, a plurality of photoelectric conversion elements formed on the semiconductor substrate, a transparent seal member, a package in which the semiconductor substrate is sealed with the transparent seal member, and a light absorbing member of a single performance disposed on the transparent seal member side with respect to the photoelectric conversion elements in the package and configured to absorb ultraviolet rays with regard to the photoelectric conversion elements.

In the solid-state image pickup device, the light absorbing member of a single performance is disposed in the inside of the package thereof. Accordingly, the light absorbing member disposed in the inside of the package absorbs ultraviolet rays. Consequently, even if color light incoming to the package includes light in the ultraviolet region, desired color light which includes reduced noise as a result of removal of the light in the ultraviolet region is received by the photoelectric conversion elements.

According to further embodiments of the present invention, the solid-state image pickup devices can be incorporated in a color separation image pickup optical system and an image pickup apparatus.

In particular, according to a further embodiment of the present invention, there is provided a color separation image pickup optical system including a color separation section configured to separate incident light into a plurality of color light components, a plurality of solid-state image pickup devices configured to individually receive the color light components separated by the color separation section, at least one of the solid-state image pickup devices including a semiconductor substrate on which a plurality of photoelectric conversion elements are formed and which is sealed in a package with a transparent seal member, and a color light absorbing member of a single performance disposed on the transparent seal member side with respect to the photoelectric conversion elements in the package and configured to absorb color light in a particular visible wavelength region with regard to the photoelectric conversion elements.

According to a still further embodiment of the present invention, there is provided a color separation image pickup optical system including a color separation section configured to separate incident light into a plurality of color light components, a plurality of solid-state image pickup devices configured to individually receive the color light components separated by the color separation section, at least one of the solid-state image pickup devices including a semiconductor substrate on which a plurality of photoelectric conversion elements are formed and which is sealed in a package with a transparent seal member, a light absorbing member of a single performance disposed on the transparent seal member side with respect to the photoelectric conversion elements in the package and configured to absorb ultraviolet rays with regard to the photoelectric conversion elements, at least a remaining one of the solid-state image pickup devices including a semiconductor substrate on which a plurality of photoelectric conversion elements are formed and which is sealed in a package with a transparent seal member, and a color light absorbing member of a single performance disposed on the transparent seal member side with respect to the photoelectric conversion elements in the package of the remaining solid-state image pickup device and configured to absorb color light in a particular visible wavelength region with regard to the photoelectric conversion elements of the remaining solid-state image pickup device.

In the color separation image pickup optical systems, there is no necessity to dispose a color light absorbing member on the outside of the solid-state image pickup device. Therefore, the color separation image pickup optical systems can be formed in a small size and at a low cost. Further, since a reflecting filter formed from a dichroic film need not be provided on the outside of the solid-state image pickup device, otherwise possible multiple reflection which may be caused by and between the reflecting filter and some other optical member or the solid-state image pickup device can be prevented.

According to a yet further embodiment of the present invention, there is provided an image pickup apparatus including an image pickup lens system, a color separation image pickup optical system including a color separation section configured to separate the incident light taken in through the image pickup lens system into a plurality of color light components and a plurality of solid-state image pickup devices configured to individually receive the color light components separated by the color separation section, at least one of the solid-state image pickup devices including a semiconductor substrate on which a plurality of photoelectric conversion elements are formed and which is sealed in a package with a transparent seal member, and a color light absorbing member of a single performance disposed on the transparent seal member side with respect to the photoelectric conversion elements in the package and configured to absorb color light in a particular visible wavelength region with regard to the photoelectric conversion elements.

According to a yet further embodiment of the present invention, there is provided an image pickup apparatus including an image pickup lens system, a color separation image pickup optical system including a color separation section configured to separate the incident light taken in through the image pickup lens system into a plurality of color light components and a plurality of solid-state image pickup devices configured to individually receive the color light components separated by the color separation section, at least a remaining one of the solid-state image pickup devices including a semiconductor substrate on which a plurality of photoelectric conversion elements are formed and which is sealed in a package with a transparent seal member, and a color light absorbing member of a single performance disposed on the transparent seal member side with respect to the photoelectric conversion elements in the package of the remaining solid-state image pickup device and configured to absorb color light in a particular visible wavelength region with regard to the photoelectric conversion elements of the remaining solid-state image pickup device.

In both of the image pickup apparatus, the color separation image pickup optical systems are used individually. Therefore, the image pickup apparatus can be formed in a small size and at a low cost.

The solid-state image pickup devices, color separation image pickup optical systems and image pickup apparatus may further include a plurality of microlenses configured to individually introduce light incoming through the transparent seal member to the photoelectric conversion elements, the light absorbing member being positioned between the photoelectric conversion elements and the microlenses. Thus, color light having passed through the color light absorbing member or light absorbing member is received efficiently by the photoelectric conversion elements.

The above and other features and advantages of the present invention will become apparent from the following description and the appended claims, taken in conjunction with the accompanying drawings in which like parts or elements denoted by like reference symbols.

### BRIEF DESCRIPTION OF THE DRAWINGS

FIG. 1 is a schematic view showing a solid-state image pickup device to which an embodiment of the present invention is applied;
FIG. 2 is a schematic view of the solid-state image pickup device showing an enlarged cross section of part of the solid-state image pickup device;
FIG. 3 is a schematic view showing an optical configuration of a color separation image pickup optical system to which an embodiment of the present invention is applied;
FIG. 4 is a diagram illustrating a spectral characteristic of light reflected by a dichroic film which reflects green light;
FIG. 5 is a diagram illustrating a spectral characteristic of the light reflected by a dichroic film which reflects blue light after green light is removed;
FIG. 6 is a diagram illustrating a spectral characteristic of light passing through the dichroic film which reflect greens light after the green light is removed;
FIG. 7 is a diagram illustrating a spectral transmission characteristic of a color light absorbing member which absorbs color light other than blue light;
FIG. 8 is a diagram illustrating a spectral transmission characteristic of a color light absorbing member which absorbs color light other than red light;
FIG. 9 is a diagram illustrating a spectral characteristic of light received by a photoelectric conversion element of a solid-state image pickup device for receiving blue light;
FIG. 10 is a diagram illustrating a spectral characteristic of light received by a photoelectric conversion element of a solid-state image pickup device for receiving red light;
FIG. 11 is a schematic view showing an optical configuration of another color separation image pickup optical system to which an embodiment of the present invention is applied;
FIG. 12 is a schematic view showing an optical configuration of a further color separation image pickup optical system to which an embodiment of the present invention is applied; and
FIG. 13 is a block diagram showing an image pickup apparatus to which an embodiment of the present invention is applied.

### DETAILED DESCRIPTION OF THE PREFERRED EMBODIMENT

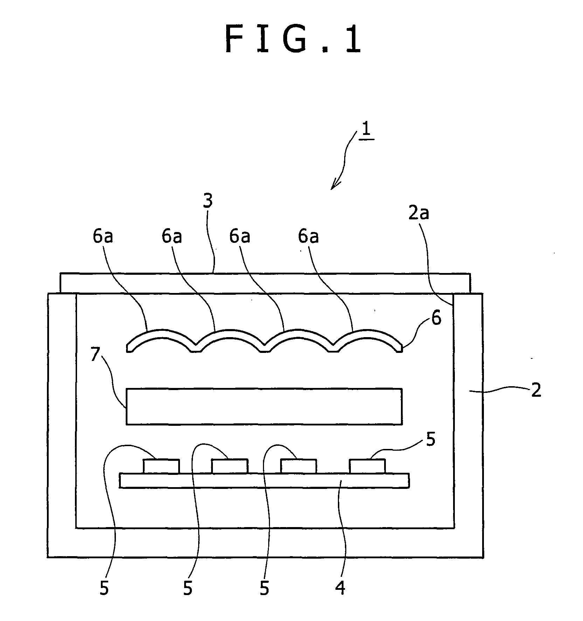

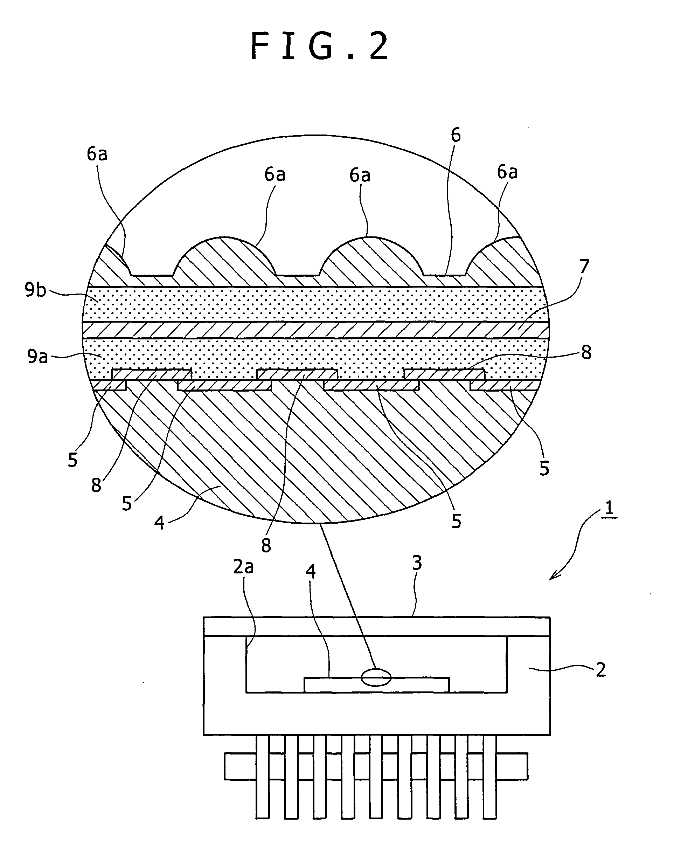

First, a solid-state image pickup device to which an embodiment of the present invention is applied is described with reference to FIGS. 1 and 2.

FIG. 1 is a sectional view showing the solid-state image pickup device 1.

Referring first to FIG. 1, the solid-state image pickup device 1 includes a package 2 in the form of a vessel which is open on one side thereof. The opening face of the package 2, that is, a face 2a to which light is inputted, is sealed, for example, with seal glass plate 3 so that the inside of the package 2 is closed up. A plurality of photoelectric conversion elements 5 each in the form of a CCD element, a CMOS element or the like are arrayed on a semiconductor substrate 4 in the enclosed package 2. A microlens array 6 is disposed between the photoelectric conversion elements 5 and the seal glass plate 3. The microlens array 6 has microlenses 6a formed thereon in an individually corresponding relationship to the photoelectric conversion elements 5 such that the microlenses 6a allow light incoming through the face 2a to be received wastelessly by the photoelectric conversion elements 5. A color light absorbing member 7 of a single performance which absorbs color light of a particular visible wavelength band is disposed between the microlens array 6 and the photoelectric conversion elements 5.

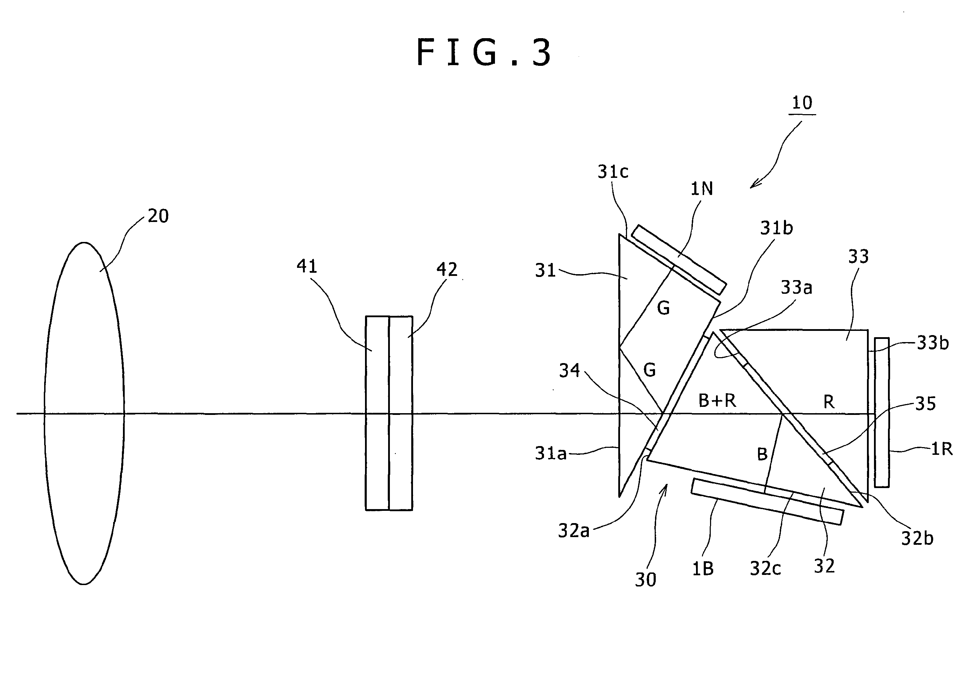

Where the color light absorbing member 7 is incorporated in a solid-state image pickup device 1B (refer to FIGS. 3, 11 and 12) for receiving only blue light from within the incident light, the performance thereof is to pass a blue light component therethrough but absorb the other color light components than the blue light component. Where the color light absorbing member 7 is incorporated in a solid-state image pickup device 1R (refer to FIGS. 3, 11 and 12) for receiving only red light, the performance thereof is to pass only a red light component therethrough but absorb the other color light components than the red light component. Where the color light absorbing member 7 is incorporated in a solid-state image pickup device (not shown) for receiving the remaining part of the incident light from which light in an ultraviolet region is removed, it absorbs ultraviolet rays.

In the solid-state image pickup device 1, since color light components other than a color light component of a reception object color are removed from within light incoming through the seal glass plate 3 and condensed on the photoelectric conversion elements 5 individually by the microlenses 6a, only the light component of the desired color is received by the photoelectric conversion elements 5.

The solid-state image pickup device 1 described above can be fabricated readily by a solid-state image pickup device fabrication method which is used popularly, and addition of the color light absorbing member 7 does not give rise to remarkable increase of the cost.

FIG. 2 shows details of the solid-state image pickup device 1 which uses, for example, a CCD device for the photoelectric conversion elements 5.

Referring to FIG. 2, the photoelectric conversion elements 5, color light absorbing member 7 and microlens array 6 are layered in order from below on the semiconductor substrate 4. The semiconductor substrate 4 is secured, for example, by adhesion to the bottom face of the package 2, which is made of a ceramic material and is open on one side thereof. The face 2a of the package 2 is covered with the seal glass plate 3.

First, the photoelectric conversion elements 5 are formed on the semiconductor substrate 4. Though not particularly shown, each of the photoelectric conversion elements 5 includes a CCD formed on the semiconductor substrate 4, a photodiode, a channel stop, and a transfer gate. Then, a light intercepting film 8 typically of aluminum is formed on the layer on which the photoelectric conversion elements 5 are formed so as to cover over any other portion than the photodiodes so that light is received only by the photodiodes. Then, charge generated in the photodiodes by reception of light is transferred to the CCDs. Then, a first flattened layer 9a is formed on the light intercepting film 8, and color filters, that is, the color light absorbing member 7, is formed on the first flattened layer 9a. Thereafter, a second flattened layer 9b is formed on the first flattened layer 9a, and the microlens array 6 is formed finally.

FIGS. 3 to 10 show a color separation image pickup optical system 10 to which an embodiment of the present invention is applied.

Referring first to FIG. 3, the color separation image pickup optical system 10 shown separates light having passed through an image pickup lens 20 into three color light components of green light G, blue light B and red light R and receives the three color light components by means of individual solid-state image pickup devices. The color separation image pickup optical system 10 is disposed rearwardly of the image pickup lens 20, that is, on the image plane side with respect to the image pickup lens 20 and includes a color separation optical system 30 and three solid-state image pickup devices 1N, 1B and 1R.

The color separation optical system 30 includes three prisms 31, 32 and 33 and two dichroic films 34 and 35. The first prism 31 is disposed such that an incidence face 31a thereof is opposed to the image pickup lens 20. The second prism 32 is joined at an incidence face 32a thereof to an emergence face 31b of the first prism 31, which is positioned on the image place side with respect to the incidence face 31a, with the dichroic film 34 interposed therebetween. The third prism 33 is joined at an incidence face 33a thereof to an emergence face 32b of the second prism 32, which is positioned on the image plane side with respect to the incidence face 32a, with the other dichroic film 35 interposed therebetween.

The solid-state image pickup device 1N is disposed in a state wherein the seal glass plate 3 thereof is opposed to the other emergence face 31c of the first prism 31, and the solid-state image pickup device 1B is disposed in a state wherein the seal glass plate 3 thereof is opposed to the other emergence face 32c of the second prism 32. Furthermore, the solid-state image pickup device 1R is disposed in a state wherein the seal glass plate 3 thereof is positioned on the image plane side with respect to the incidence face 33a of the third prism 33 and is opposed to the emergence face 33b extending in parallel to the image pickup lens 20. It is to be noted that the seal glass plates 3 of the solid-state image pickup devices 1N, 1B and 1R may be adhered to the emergence faces 31c, 32c and 33b, respectively, or may be disposed in a spaced relationship from the emergence faces 31c, 32c and 33b with an air gap left therebetween, respectively. Further, an optical low-pass filter 41 or an infrared cut filter 42 may be disposed between the color separation image pickup optical system 10 and the image pickup lens 20.

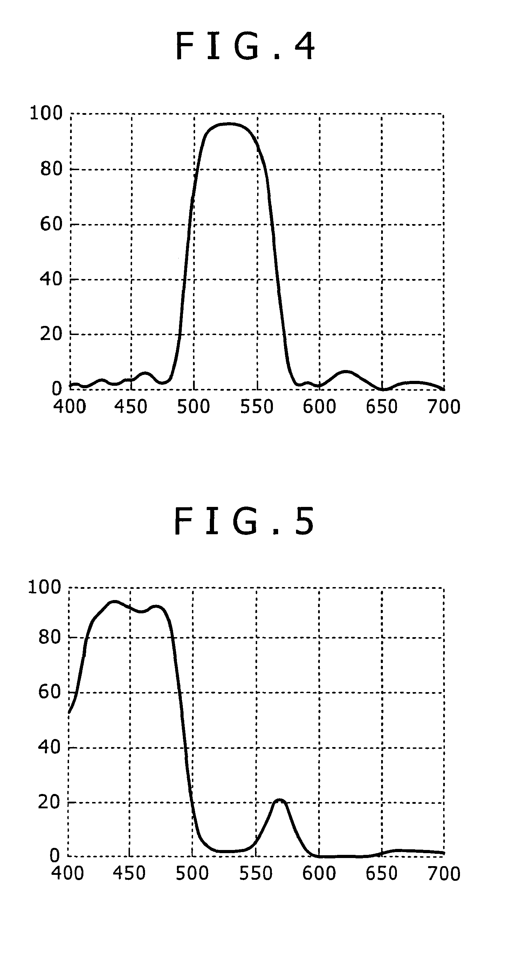

In the color separation image pickup optical system 10 having the configuration described above, light passing through the image pickup lens 20 and entering the first prism 31 through the incidence face 31a comes to the dichroic film 34 form on the emergence face 31b of the first prism 31. Then, a green light component G of the light is reflected by the dichroic film 34 while the other color light components pass through the dichroic film 34 and enter the second prism 32 through the incidence face 31a. The green light G reflected by the dichroic film 34 is reflected by the inner face of the incidence face 31a and then passes through the other emergence face 31c, whereafter it enters the solid-state image pickup device 1N. It is to be noted that the solid-state image pickup device 1N is of the monochromatic type which does not include the color light absorbing member 7. FIG. 4 illustrates a spectral characteristic of the green light G reflected by the dichroic film 34. As seen in FIG. 4, the spectral characteristic exhibits rather low spectral components except the green light and does not exhibit a conspicuously high peak. Therefore, even if the color light absorbing member 7 which absorbs color light components other than the green light from within the light introduced into the solid-state image pickup device 1N is not provided, green light which includes little noise is received by the photoelectric conversion elements 5. It is to be noted that the color light absorbing member 7 for absorbing color light components other than the green light may be provided in the solid-state image pickup device 1 for receiving the green light. This makes it possible to receive only green light with a higher degree of certainty.

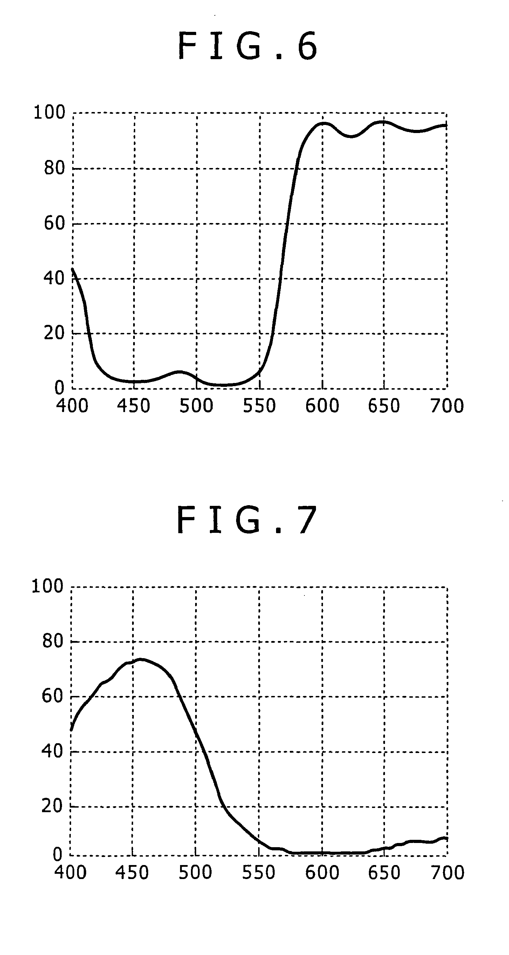

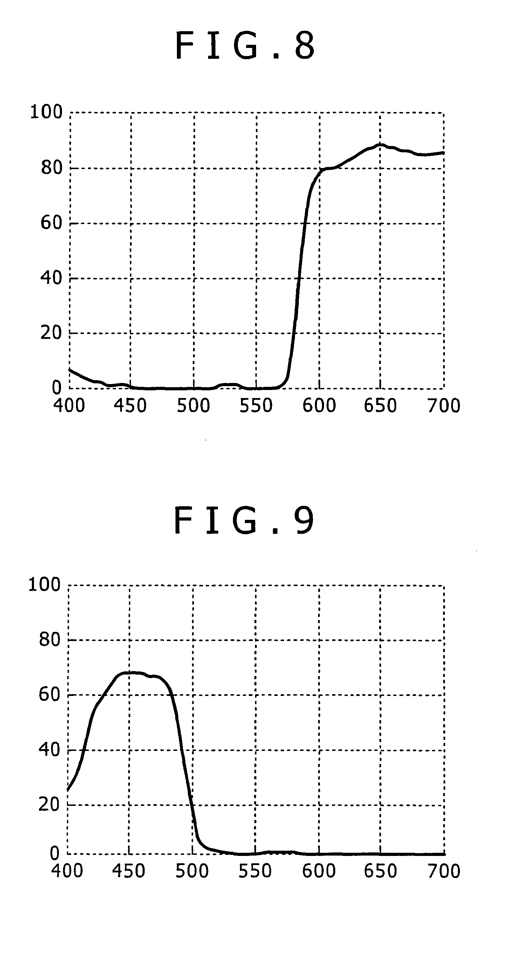

Referring back to FIG. 3, the light passing through the dichroic film 34 enters the second prism 32 through the incidence face 32a and comes to the dichroic film 35 formed on the emergence face 32b. Then, blue light B is reflected by the dichroic film 35 while red light R passes through the dichroic film 35. The blue light B reflected by the dichroic film 35 goes out from the second prism 32 through the emergence face 32c and enters the solid-state image pickup device 1B. The color light absorbing member 7 provided on the solid-state image pickup device 1B is formed so as to absorb color light components other than blue light. Accordingly, from the blue light B incident to the solid-state image pickup device 1B, color light components other than the blue light are absorbed by the color light absorbing member 7. Consequently, blue light including little noise is received. FIG. 5 illustrates a spectral characteristic of light reflected by the dichroic film 35 which reflects blue light from within the light from which the green light is removed. From FIG. 5, a high peak of surplus color light is found in the proximity of 570 nm (nanometer), and this makes noise. However, the spectral transmission factor characteristic of the color light absorbing member 7 provided in the solid-state image pickup device 1B is such that color light components having a wavelength shorter than 500 nm of the blue region are passed to the utmost and the other color light components are absorbed as seen in FIG. 7. Therefore, light in the proximity of 570 nm is absorbed while blue light having such a spectral characteristic as seen in FIG. 9 is received by the photoelectric conversion elements 5.

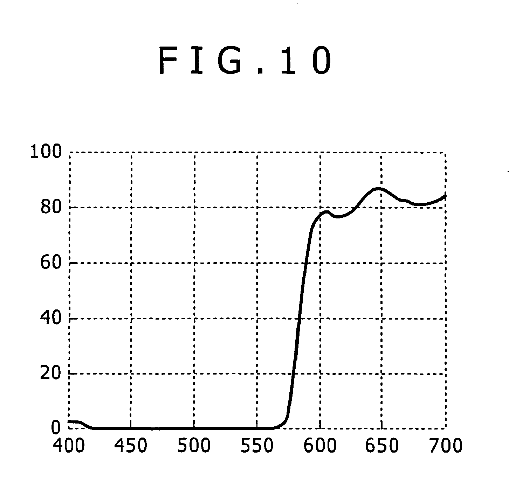

Referring back again to FIG. 3, the red light R passing through the dichroic films 34 and 35 enters the solid-state image pickup device 1R and passes through the color light absorbing member 7 provided in the solid-state image pickup device 1R and is then received by the photoelectric conversion elements 5. Then, the red light R passing through the dichroic prisms 34 and 35 exhibits a peak of surplus light in the proximity of 400 nm as seen from the spectral characteristic of FIG. 6. Further, the spectral transmission characteristic of the color light absorbing member 7 provided in the solid-state image pickup device 1R is such that color light components having a wavelength shorter than a wavelength around 570 nm is little passed as seen in FIG. 8. Therefore, surplus light components having a wavelength in the proximity of 400 nm which are found in FIG. 6 are removed, and only such red light which includes little noise as seen from a spectral characteristic illustrated in FIG. 10 is received by the photoelectric conversion elements 5. It is to be noted that the light path lengths of the color light components G, B and R after they enter the incidence face 31a of the first prism 31 until they come to the light receiving faces of the photoelectric conversion elements 5 of the solid-state image pickup devices 1N, 1B and 1R are equal to each other.

As described hereinabove, in the color separation image pickup optical system 10, green light G, blue light B and red light R from which noise is removed almost completely are received by the solid-state image pickup devices 1N, 1B and 1R, respectively. Further, a filter or an ultraviolet reflecting film which is conventionally required is not required for the color separation optical system 30. Consequently, the size and the cost can be reduced as much.

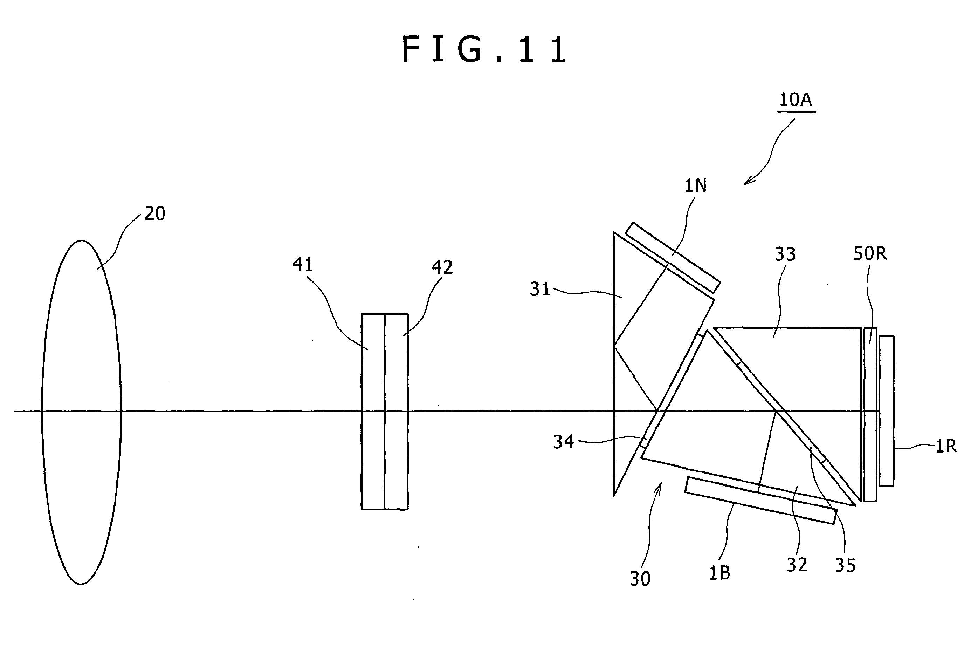

FIG. 11 shows another color separation image pickup optical system to which an embodiment of the present invention is applied. The color separation image pickup optical system 10A of the present embodiment is a modification to the color separation image pickup optical system 10 described hereinabove with reference to FIG. 3. The color separation image pickup optical system 10A is different from the color separation image pickup optical system 10 in that a wavelength selective filter 50R for absorbing color light components other than red color light is interposed between the emergence face 33b of the third prism 33 and the solid-state image pickup device 1R.

Where the wavelength selective filter 50R is used, although the merit of the miniaturization is somewhat lost, color light components other than red light can be removed more fully.

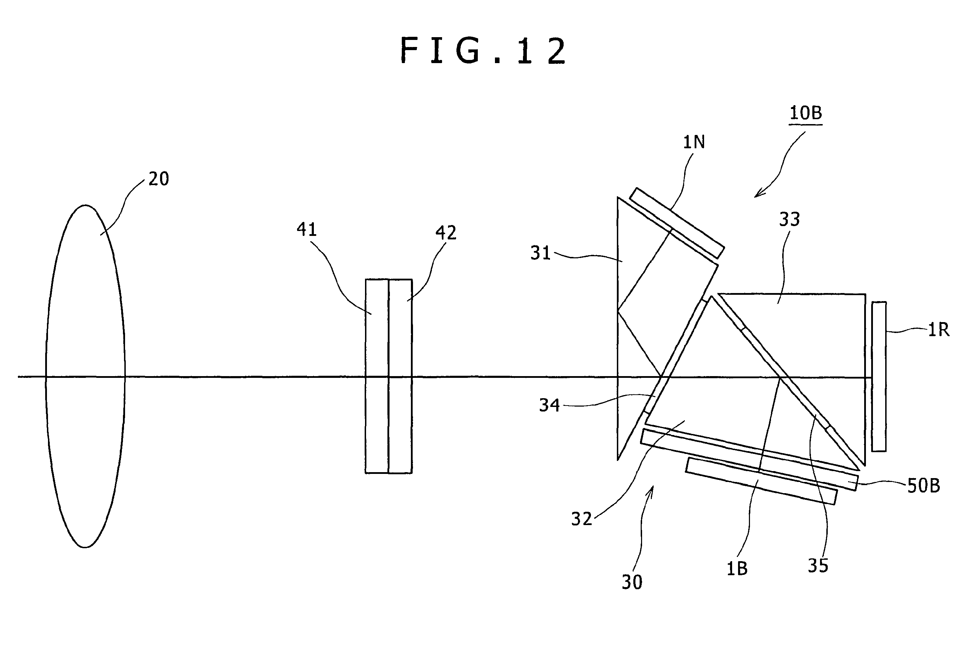

FIG. 12 shows a further color separation image pickup optical system to which an embodiment of the present invention is applied. The color separation image pickup optical system 10B is a modification to but is different from the color separation image pickup optical system 10 shown in FIG. 3 in that a wavelength selective filter 50B for absorbing color light components other than blue light is interposed between the emergence face 32b of the second prism 32 and the solid-state image pickup device 1B.

Where the wavelength selective filter 50B is used, although the merit of the miniaturization is somewhat lost, color light components other than blue light can be removed more fully.

It is to be noted that a plurality of wavelength selective filters 50 may be provided immediately forwardly of a plurality of solid-state image pickup devices 1.

Further, in the color separation image pickup optical systems 10, 10A and 10B described hereinabove, a solid-state image pickup device including a light absorbing member for absorbing ultraviolet rays may be disposed in place of the solid-state image pickup device 1R. Since light passing through the dichroic film 35 includes noise light having a peak in the proximity of 400 nm as described hereinabove with reference to FIG. 6, such noise light in the proximity of 400 nm can be removed by absorbing the ultraviolet rays.

It is to be noted that, in the color separation image pickup optical systems 10, 10A and 10B described hereinabove, green light, blue right and red light are separated in order, the order of separation of the color light components is not limited to this.

Also the number of color light components to be separated is not limited to three, but light may be separated into a different number of color light components such as two color light components or four or more color light components.

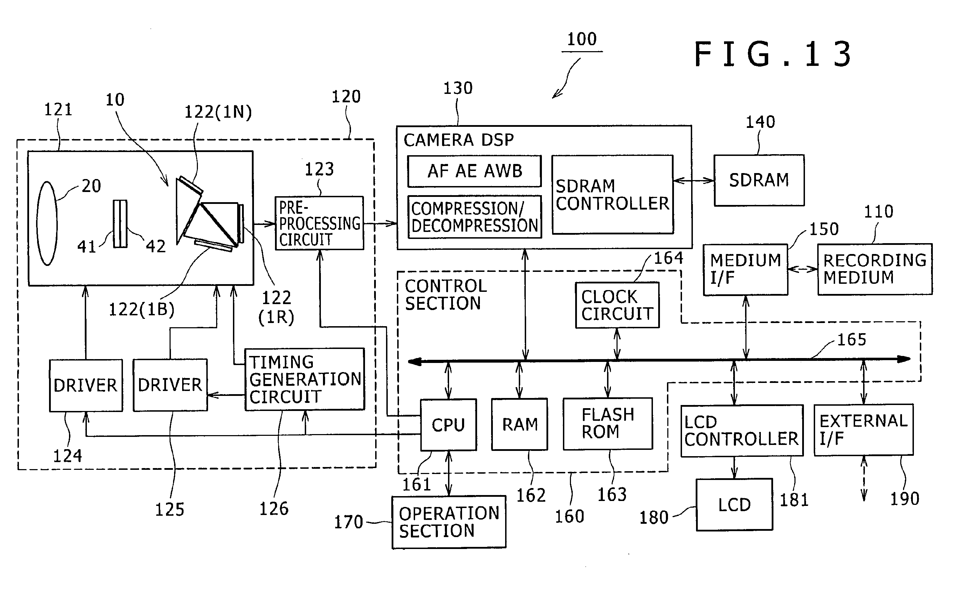

FIG. 13 shows an image pickup apparatus to which an embodiment of the present invention is applied.

Referring to FIG. 13, the image pickup apparatus 100 shown includes, as principal components thereof, a camera section 120, a camera DSP (Digital Signal Processor) 130, an SDRAM (Synchronous Dynamic Random Access Memory) 140, and a medium interface (medium I/F) 150. The image pickup apparatus 100 further includes a control section 160, an operation section 170, an LCD unit (Liquid Crystal Display) 180, and an external interface (external I/F) 190. A recording medium 110 is removably loaded into the image pickup apparatus 100.

For the recording medium 110, various media can be used such as memory cards which include a semiconductor memory, optical recording media such as a recordable DVD (Digital Versatile Disk) and a recordable CD (Compact Disc) and magnetic disks. In the following description, it is assumed that a memory card is used as the recording medium 110.

The camera section 120 includes an optical block 121, a preprocessing circuit 123, an optical block driver 124, a CCD driver 125 and a timing generation circuit 126. The optical block 121 includes a lens, a focusing mechanism, a shutter mechanism, an iris mechanism and so forth. The optical block 121 further includes an image pickup lens 20 and a color separation image pickup optical system 10 (or 10A or 10B), and the solid-state image pickup devices 1 of the color separation image pickup optical system 10 include CCD units 122. Thus, in the camera section 120, an image separated for the individual colors of R, G and B is fetched by the three solid-state image pickup devices, and the fetched individual color images are superposed to produce information of a single color image.

The control section 160 is formed as a microcomputer wherein a CPU (Central Processing Unit) 161, a RAM (Random Access Memory) 162, a ROM (Read Only Memory) 163, a clock circuit 164 and so forth are interconnected by a system bus 165. The control section 160 controls the components of the image pickup apparatus 100.

The RAM 162 is used principally as a working area for temporarily storing intermediate results of processing. The ROM 163 has stored therein various programs to be executed by the CPU 161 and data necessary for processing by the CPU 161. The clock circuit 164 can provide the year, month and date at present, the day of the week at present and the time at present and can provide the date and hour of image pickup.

Upon image pickup, the optical block driver 124 forms a driving signal for rendering the optical block 121 operative under the control of the control section 160 and supplies the produced driving signal to the optical block 121 so that the optical block 121 may operate. The optical block 121 is controlled by the driving signal from the optical block driver 124 so that the focusing mechanism, shutter mechanism and iris mechanism operate to fetch an image of an image pickup subject and provide the fetched image to the CCD units 122.

The CCD units 122 photoelectrically convert the image from the optical block 121 and output resulting image signals. In particular, the CCD units 122 operate in response to the driving signal from the CCD driver 125 to fetch the image of the image pickup subject from the optical block 121 and supply the fetched image (image information) of the image pickup subject as electric signals to the preprocessing circuit 123 in response to a timing signal from the timing generation circuit 126 which is controlled by the control section 160.

It is to be noted that the timing generation circuit 126 forms a timing signal for providing a predetermined timing under the control of the control section 160. Further, the CCD driver 125 forms a driving signal to be supplied to the CCD units 122 in response to a timing signal from the timing generation circuit 126.

The preprocessing circuit 123 performs a CDS (Correlated Double Sampling) process for the image information of the electric signals supplied thereto so that the image information may have a good S/N ratio. The preprocessing circuit 123 further performs an AGC (Automatic Gain Control) process for the image information to control the gain of the image information. Then, the preprocessing circuit 123 performs A/D (Analog/Digital) conversion of the resulting image information to form image data in the form of a digital signal.

The image data in the form of a digital signal from the preprocessing circuit 123 is supplied to the camera DSP 130. The camera DSP 130 performs signal processes such as an AF (Auto Focusing) process, an AE (Auto Exposure) process and an AWB (Auto White Balance) process for the image data supplied thereto. The image data for which various adjustments have been performed in this manner is compressed in accordance with a predetermined compression method. The compressed image data is supplied to the recording medium 110 loaded in the image pickup apparatus 100 through the system bus 165 and the medium I/F 150 and is recorded as a file on the recording medium 110.

Object image data from among image data recorded in the recording medium 110 is read out from the recording medium 110 through the medium I/F 150 in response to an operation input of a user accepted through the operation section 170 which may include a touch panel and/or control keys. The image data read out in this manner is supplied to the camera DSP 130.

The camera DSP 130 performs a decompression process for the compressed image data read out from the recording medium 110 and supplied thereto through the medium I/F 150. Then, the camera DSP 130 supplies the decompressed image data to an LCD controller 181 through the system bus 165. The LCD controller 181 forms an image signal to be supplied to the LCD unit 180 from the image data supplied thereto and supplies the image signal to the LCD unit 180. Consequently, an image corresponding to the image data recorded in the recording medium 110 is displayed on a display screen of the LCD unit 180.

It is to be noted that the image is displayed in a form defined by a display processing program recorded in the ROM 163. This display program defines in what scheme a file system hereinafter described is recorded and in what manner an image is to be reproduced.

The image pickup apparatus 100 further includes an external I/F 190. The image pickup apparatus 100 can be connected, for example, to an external personal computer through the external I/F 190. Consequently, the image pickup apparatus 100 can receive supply of image data from the external personal computer and record the image data on the recording medium 110 loaded therein. Further, the image pickup apparatus 100 can supply image data recorded on the recording medium 110 loaded therein to the external personal computer or the like.

Or, a communication module may be connected to the external I/F 190. In this instance, the image pickup apparatus 100 can be connected to a network such as, for example, the Internet, and acquire image data or other information through the network and record various the image data and so forth on the recording medium 110 loaded therein. Further, the image pickup apparatus 100 can transmit data recorded on the recording medium 110 loaded thereon to an object party of communication through the network.

Naturally, also information such as image data acquired from the external personal computer or through the network and recorded on a recording medium can be read out and reproduced by the image pickup apparatus and then displayed on the LCD unit 180 so that the user can utilize the information.

It is to be noted that the external I/F 190 may be provided as a wired interface such as an IEEE (Institute of Electrical and Electronics Engineers) 1394 interface or a USB (Universal Serial bus) interface or as a wireless interface which makes use of light or radio waves. In other words, the external I/F 190 may be any of wired and wireless interfaces.

In this manner, the image pickup apparatus 100 can pick up an image of an image pickup subject and record the picked up image on the recording medium 110 loaded therein. Further, the image pickup apparatus 100 can read out image data recorded on the recording medium 110 and reproduce the image data so as to be utilized. Further, the image pickup apparatus 100 can receive supply of image data from an external personal computer or through a network and record the image data on the recording medium 110 loaded therein, and besides can read out and reproduce the image data recorded on the recording medium 110.

It is to be noted that, while a CCD device is used as the image pickup section in the image pickup apparatus 100 described above, the image pickup section in the image pickup apparatus to which an embodiment of the present invention is applied is not limited to a CCD device. Also it is possible to use a CMOS (Complementary Metal-Oxide Semiconductor) device or some other image pickup device in place of a CCD device.

While preferred embodiments of the present invention have been described using specific terms, such description is for illustrative purpose only, and it is to be understood that changes and variations may be made without departing from the spirit or scope of the following claims.

## Claims

1. A solid-state image pickup device, comprising:
a semiconductor substrate;
a plurality of photoelectric conversion elements formed on said semiconductor substrate;
a transparent seal member;
a package in which said semiconductor substrate is sealed with said transparent seal member; and
a color light absorbing member of a single performance disposed on said transparent seal member side with respect to said photoelectric conversion elements in said package and configured to absorb color light in a particular visible wavelength region with regard to said photoelectric conversion elements.

2. The solid-state image pickup device according to claim 1, further comprising a plurality of microlenses configured to individually introduce light incoming through said transparent seal member to said photoelectric conversion elements, said color light absorbing member being positioned between said photoelectric conversion elements and said microlenses.

3. A solid-state image pickup device, comprising:
a semiconductor substrate;
a plurality of photoelectric conversion elements formed on said semiconductor substrate;
a transparent seal member;
a package in which said semiconductor substrate is sealed with said transparent seal member; and
a light absorbing member of a single performance disposed on said transparent seal member side with respect to said photoelectric conversion elements in said package and configured to absorb ultraviolet rays with regard to said photoelectric conversion elements.

4. The solid-state image pickup device according to claim 3, further comprising a plurality of microlenses configured to individually introduce light incoming through said transparent seal member to said photoelectric conversion elements, said light absorbing member being positioned between said photoelectric conversion elements and said microlenses.

5. A color separation image pickup optical system, comprising:
a color separation section configured to separate incident light into a plurality of color light components;
a plurality of solid-state image pickup devices configured to individually receive the color light components separated by said color separation section;
at least one of said solid-state image pickup devices including a semiconductor substrate on which a plurality of photoelectric conversion elements are formed and which is sealed in a package with a transparent seal member; and
a color light absorbing member of a single performance disposed on said transparent seal member side with respect to said photoelectric conversion elements in said package and configured to absorb color light in a particular visible wavelength region with regard to said photoelectric conversion elements.

6. The color separation image pickup optical system according to claim 5, further comprising a plurality of microlenses configured to individually introduce light incoming through said transparent seal member to said photoelectric conversion elements, said color light absorbing member being positioned between said photoelectric conversion elements and said microlenses.

7. A color separation image pickup optical system, comprising:
a color separation section configured to separate incident light into a plurality of color light components;
a plurality of solid-state image pickup devices configured to individually receive the color light components separated by said color separation section;
at least one of said solid-state image pickup devices including a semiconductor substrate on which a plurality of photoelectric conversion elements are formed and which is sealed in a package with a transparent seal member;
a light absorbing member of a single performance disposed on said transparent seal member side with respect to said photoelectric conversion elements in said package and configured to absorb ultraviolet rays with regard to said photoelectric conversion elements;
at least a remaining one of said solid-state image pickup devices including a semiconductor substrate on which a plurality of photoelectric conversion elements are formed and which is sealed in a package with a transparent seal member; and
a color light absorbing member of a single performance disposed on said transparent seal member side with respect to said photoelectric conversion elements in said package of the remaining solid-state image pickup device and configured to absorb color light in a particular visible wavelength region with regard to said photoelectric conversion elements of the remaining solid-state image pickup device.

8. The color separation image pickup optical system according to claim 7, further comprising a plurality of microlenses disposed in each of the packages and configured to individually introduce light incoming through said transparent seal member to said photoelectric conversion elements, said color light absorbing member being positioned between said photoelectric conversion elements and said microlenses in each of the packages.

9. An image pickup apparatus, comprising:
an image pickup lens system;
a color separation image pickup optical system including a color separation section configured to separate the incident light taken in through said image pickup lens system into a plurality of color light components and a plurality of solid-state image pickup devices configured to individually receive the color light components separated by said color separation section;
at least one of said solid-state image pickup devices including a semiconductor substrate on which a plurality of photoelectric conversion elements are formed and which is sealed in a package with a transparent seal member; and
a color light absorbing member of a single performance disposed on said transparent seal member side with respect to said photoelectric conversion elements in said package and configured to absorb color light in a particular visible wavelength region with regard to said photoelectric conversion elements.

10. The image pickup apparatus according to claim 9, further comprising a plurality of microlenses configured to individually introduce light incoming through said transparent seal member to said photoelectric conversion elements, said color light absorbing member being positioned between said photoelectric conversion elements and said microlenses.

11. An image pickup apparatus, comprising:
an image pickup lens system;
a color separation image pickup optical system including a color separation section configured to separate the incident light taken in through said image pickup lens system into a plurality of color light components and a plurality of solid-state image pickup devices configured to individually receive the color light components separated by said color separation section;
at least a remaining one of said solid-state image pickup devices including a semiconductor substrate on which a plurality of photoelectric conversion elements are formed and which is sealed in a package with a transparent seal member; and
a color light absorbing member of a single performance disposed on said transparent seal member side with respect to said photoelectric conversion elements in said package of the remaining solid-state image pickup device and configured to absorb color light in a particular visible wavelength region with regard to said photoelectric conversion elements of the remaining solid-state image pickup device.

12. The image pickup apparatus according to claim 11, further comprising a plurality of microlenses configured to individually introduce light incoming through said transparent seal member to said photoelectric conversion elements, said light absorbing member being positioned between said photoelectric conversion elements and said microlenses.
